# EUROPEAN PATENT APPLICATION

(11) **EP 4 528 979 A1**
(43) Date of publication of application: **26.03.2025**
(21) Application number: 23896348.2
(22) Date of filing: 26.10.2023
(51) Int. Cl.: H02J 50/00, H02J 7/00

(54) **WIRELESS CHARGING MODULE AND VEHICLE**

(30) Priority: 29.11.2022 CN 202211509363
(71) Applicant: Nio Smart Technology Co., Ltd., Shanghai 201800 (CN)
(72) Inventor: ZHAO, Dongxing, Shanghai 201800 (CN)
(74) Representative: Patentanwaltskanzlei WILHELM & BECK
(86) International application number: PCT/CN2023/126812
(87) International publication number: WO 2024/114193

(57) **Abstract**

The disclosure discloses a wireless charging module and a vehicle. The wireless charging module includes a transmitting coil, a heat conducting assembly, a thermoelectric cooler, a heat dissipation assembly and a control board. The transmitting coil is used for cooperating with a mobile terminal to conduct charging; the heat conducting assembly is used for contacting with the mobile terminal and conducting heat generated by the mobile terminal; the thermoelectric cooler is provided with a cold end and a hot end, and the cold end is thermally connected to the heat conducting assembly; the heat dissipation assembly is thermally connected to both the hot end and the transmitting coil, and the heat dissipation assembly is located on a side of the transmitting coil away from the mobile terminal; and the control board is electrically connected to both the transmitting coil and the thermoelectric cooler.

## Description

### Technical Field

The disclosure relates to the technical field of vehicles, and in particular to a wireless charging module and a vehicle.

### Background Art

A vehicle-mounted wireless charging module is provided with a transmitting coil, and a mobile terminal (such as a mobile phone or a tablet) is provided with a receiving coil. When the mobile terminal cooperates with the wireless charging module, the transmitting coil and the receiving coil interact with each other by means of electromagnetic induction, thus realizing the charging of the mobile terminal.

Air cooling is usually used to dissipate heat from the wireless charging module and the mobile terminal. However, air cooling has the following drawbacks.

Since an air cooling assembly needs to be arranged between the transmitting coil and the receiving coil, sufficient space must be reserved as an air duct on a side of the wireless charging module used for receiving the mobile terminal. As a result, the transmitting coil is arranged further from the receiving coil due to the existence of the air duct, resulting in increased magnetic loss and reduced charging efficiency. In addition, the air duct also makes it easy for external foreign objects (for example, liquids such as coffee and drinks, food residues such as bread and chips, and magnetic substances such as cards) to enter, bringing additional troubles. Moreover, the air duct is located on the side of the wireless charging module used for receiving the mobile terminal, that is, on the side facing a driver, and the noise of a fan is relatively loud.

### Summary

Based on this, in view of the problems of increased magnetic loss, low charging efficiency and easy entry of external foreign objects in traditional wireless charging modules, a wireless charging module and a vehicle are provided.

The technical solution thereof is as follows.

In a first aspect, the disclosure provides a wireless charging module. The wireless charging module includes:
a transmitting coil, the transmitting coil being used for cooperating with a mobile terminal to conduct charging;
a heat conducting assembly, the heat conducting assembly being used for contacting with the mobile terminal and conducting heat generated by the mobile terminal;
a thermoelectric cooler, the thermoelectric cooler being provided with a cold end and a hot end, and the cold end being thermally connected to the heat conducting assembly, so as to absorb the heat generated by the mobile terminal;
a heat dissipation assembly, the heat dissipation assembly being thermally connected to both the hot end and the transmitting coil, and the heat dissipation assembly being located on a side of the transmitting coil away from the mobile terminal; and
a control board, the control board being electrically connected to both the transmitting coil and the thermoelectric cooler.

According to the wireless charging module as described above, the heat conducting assembly is located on an outer side of the wireless charging module, and when the mobile terminal (such as a mobile phone or a tablet) needs to be charged, the mobile terminal is placed on the heat conducting assembly, such that the receiving coil of the mobile terminal cooperates with the transmitting coil to conduct charging; and the heat generated by the mobile terminal during charging is conducted to the cold end of the thermoelectric cooler via the heat conducting assembly and is then absorbed by the cold end, and heat generated by the hot end of the thermoelectric cooler and heat generated by the transmitting coil are both dissipated via the heat dissipation assembly, thus realizing the cooling and heat dissipation of the mobile terminal and the transmitting coil. Since the heat dissipation assembly is located on an inner side of the wireless charging module, a driver on the outside can hardly perceive wind noise. Moreover, since there is no need to reserve space for an air duct between the heat conducting assembly and the mobile terminal, the problems of increased magnetic loss and low charging efficiency caused by a large distance between a transmitting coil and a receiving coil due to the existence of the air duct is solved. In addition, no external foreign object will enter the air duct.

The technical solutions are further described below.

In an embodiment, the heat dissipation assembly includes a heat dissipation plate and at least a fan, the heat dissipation plate being thermally connected to both the hot end and the transmitting coil, and the fan being located on a side of the heat dissipation plate away from the transmitting coil.

In an embodiment, the heat dissipation assembly further includes heat dissipation fins, a plurality of heat dissipation fins being provided and being spaced apart and arranged in parallel on the heat dissipation plate, a heat dissipation gap being formed between adjacent heat dissipation fins, and the fan being capable of generating airflow towards the heat dissipation gap.

In an embodiment, the heat dissipation assembly further includes a first heat conducting layer, the first heat conducting layer is arranged on the heat dissipation plate, and the first heat conducting layer is located on a side of the heat dissipation plate away from the heat dissipation fins; and the transmitting coil, the control board and the thermoelectric cooler are all located at the same side of the heat dissipation plate and are thermally connected to the heat dissipation plate by means of the first heat conducting layer.

In an embodiment, the wireless charging module further includes a ferrite, where the ferrite is located between the first heat conducting layer and the transmitting coil.

In an embodiment, the heat conducting assembly includes a heat conducting plate, the heat conducting plate is located on a side of the transmitting coil away from the heat dissipation plate, and the heat conducting plate is used for contacting with the mobile terminal and conducting the heat generated by the mobile terminal to the cold end; and the heat conducting plate is provided with a first heat conducting part and a second heat conducting part, the second heat conducting part is arranged through the first heat conducting part, the second heat conducting part is positioned corresponding to the transmitting coil, and the second heat conducting part is made of a nonmetallic thermally conductive material.

In an embodiment, the first heat conducting part is provided with a first through hole, the first through hole is shaped corresponding to the second heat conducting part, and the second heat conducting part is arranged in the first heat conducting part by means of the first through hole.

In an embodiment, the heat conducting assembly further includes a heat conducting pipe, the heat conducting pipe being arranged on the heat conducting plate and located on a side of the heat conducting plate facing the thermoelectric cooler, and the heat conducting plate being thermally connected to the thermoelectric cooler.

In an embodiment, at least two thermoelectric coolers are provided and are arranged around the periphery of the transmitting coil; the first heat conducting part is provided with a first mounting recess, the first mounting recess is arranged around the periphery of the second heat conducting part, the heat conducting pipe is shaped corresponding to the first mounting recess and is arranged on the heat conducting plate by means of the first mounting recess, and the heat conducting pipe is thermally connected to all of the thermoelectric coolers; or/and
the heat conducting assembly further includes a second heat conducting layer, the second heat conducting layer being laid over the heat conducting plate and the heat conducting pipe, and the thermoelectric cooler being thermally connected to the heat conducting plate and the heat conducting pipe by means of the second heat conducting layer.

In another aspect, the disclosure further includes a vehicle. The vehicle includes a wireless charging module according to any one of the technical solutions described above.

The vehicle includes the wireless charging module as described above. Since the heat dissipation assembly is located on an inner side of the wireless charging module, and a driver on the outside can hardly perceive wind noise. Moreover, since there is no need to reserve space for an air duct between the heat conducting assembly and the mobile terminal, the problems of increased magnetic loss and low charging efficiency caused by a large distance between a transmitting coil and a receiving coil due to the existence of the air duct is solved. In addition, no external foreign object will enter the air duct.

### Brief Description of the Drawings

The drawings, which constitute a part of the disclosure, are intended to provide a further understanding of the disclosure, and the illustrative embodiments of the disclosure and the description thereof are intended to explain the disclosure and do not unduly limit the disclosure.

In order to more clearly illustrate the technical solutions in the embodiments of the disclosure, the drawings to be used in the description of the embodiments will be described briefly below. Obviously, the drawings in the following description are only some embodiments of the disclosure. For those of ordinary skill in the art, other drawings can also be obtained from these drawings without involving any inventive effort.

In addition, the drawings are not drawn to a scale of 1 : 1, and the relative dimensions of individual elements are drawn merely by way of example, and are not necessarily drawn to a true scale.
FIG. 1 is a schematic structure diagram of a wireless charging module and a mobile terminal according to an embodiment of the disclosure;
FIG. 2 is a schematic structure diagram of the wireless charging module according to the embodiment in FIG. 1;
FIG. 3 is a schematic diagram from another perspective of the wireless charging module according to the embodiment in FIG. 1;
FIG. 4 is a schematic exploded structure diagram of the wireless charging module according to the embodiment in FIG. 1; and
FIG. 5 is an exploded structure diagram of a heat conducting plate, a transmitting coil and a heat conducting pipe according to the embodiment in FIG. 1.

### List of reference signs:

100. wireless charging module; 110. transmitting coil; 121. heat conducting plate; 1211. first heat conducting part; 1212. first through hole; 1213. first mounting recess; 1214. second heat conducting part; 122. heat conducting pipe; 130. thermoelectric cooler; 141. heat dissipation plate; 142. fan; 143. heat dissipation fin; 144. heat dissipation gap; 150. control board; 160. ferrite; 200. mobile terminal.

### Detailed Description of Embodiments

The embodiments of the disclosure are described in detail below with reference to the drawings:
To make the above objectives, features and advantages of the disclosure clearer and more comprehensible, specific implementations of the disclosure will be described in detail below with reference to the drawings. In the following description, many specific details are set forth in order to provide a thorough understanding of the disclosure. However, the disclosure can be implemented in numerous other ways that are different from those described herein, those skilled in the art can make similar improvements without departing from the connotation of the disclosure, and therefore the disclosure is not limited to the particular embodiments disclosed below.

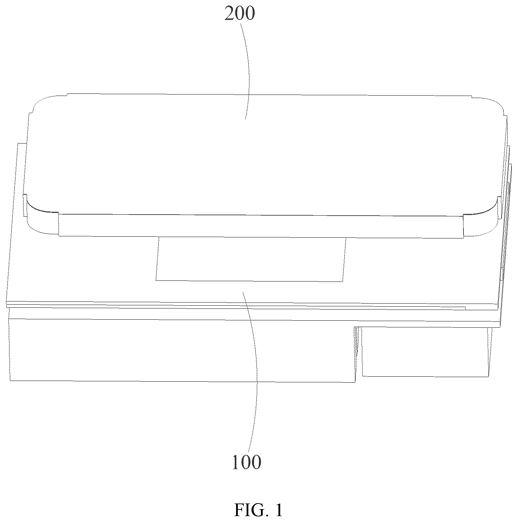

With reference to FIG. 1, a wireless charging module 100 may be provided on a vehicle, such as an electric vehicle. When a driver or other people in the vehicle need to charge their devices, a mobile device such as a mobile phone is placed on the wireless charging module 100, such that a receiving coil of the mobile device cooperates with a transmitting coil 110 of the wireless charging module 100 to conduct charging by means of electromagnetic induction.

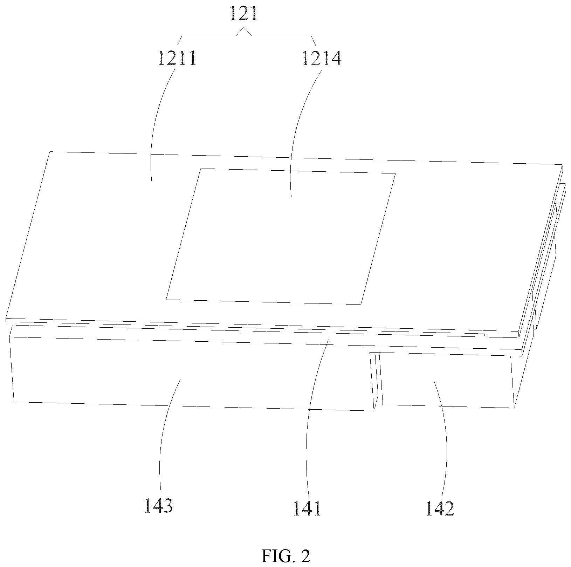

With reference to FIGS. 2 to 4, the disclosure provides a wireless charging module 100, including a transmitting coil 110, a heat conducting assembly, a thermoelectric cooler 130, a heat dissipation assembly and a control board 150.

The transmitting coil 110 is used for cooperating with a mobile terminal 200 to conduct charging.

The mobile terminal 200 (such as a mobile phone or a tablet) is provided with a receiving coil corresponding to the transmitting coil 110. When the mobile terminal 200 approaches the wireless charging module 100, the receiving coil can cooperate with the transmitting coil 110 to charge the mobile terminal 200 by means of electromagnetic induction.

The heat conducting assembly is used for contacting with the mobile terminal 200 and conducting heat generated by the mobile terminal 200.

The heat conducting assembly is arranged on an outer side of the wireless charging module 100 for placing the mobile terminal 200 and also for conducting the heat generated by the mobile terminal 200 during charging towards a cold end of the thermoelectric cooler 130, so as to cool the mobile terminal 200 via the thermoelectric cooler 130.

The thermoelectric cooler 130 is provided with a cold end and a hot end, and the cold end is thermally connected to the heat conducting assembly, so as to absorb the heat generated by the mobile terminal 200.

The thermoelectric cooler 130 (abbreviated as TEC) is a device that uses a thermoelectric effect of a semiconductor for cooling or dissipating heat. The cold end of the thermoelectric cooler 130 can absorb the heat conducted by the heat conducting assembly, so as to cool the mobile terminal 200. Of course, it can also be understood that the heat conducting assembly conducts cold of the cold end of the thermoelectric cooler 130 to the mobile terminal 200, so as to cool the mobile terminal 200.

The heat dissipation assembly is thermally connected to both the hot end and the transmitting coil 110, and the heat dissipation assembly is located on a side of the transmitting coil 110 away from the mobile terminal 200.

Heat generated by the hot end of the thermoelectric cooler 130 is dissipated via the heat dissipation assembly, and heat generated by the transmitting coil 110 is also dissipated via the heat dissipation assembly. Moreover, the heat dissipation assembly is located on the side of the transmitting coil 110 away from the mobile terminal 200, so as to solve the problem of loud wind noise perceived from the outside.

The control board 150 is electrically connected to both the transmitting coil 110 and the thermoelectric cooler 130.

The control board 150 may be a printed circuit board (PCB) or a printed circuit board assembly (PCBA). The control board 150 may be arranged between the heat conducting assembly and the heat dissipation assembly, and the control board 150 is thermally connected to the heat dissipation assembly, so as to dissipate heat via the heat dissipation assembly.

The wireless charging module 100 can be applied to the vehicle. The heat conducting assembly is located on the outer side of the wireless charging module 100, and when the mobile terminal 200 (such as a mobile phone or a tablet) needs to be charged, the mobile terminal 200 is placed on the heat conducting assembly, such that the receiving coil of the mobile terminal 200 cooperates with the transmitting coil 110 to conduct charging; and the heat generated by the mobile terminal 200 during charging is conducted to the cold end of the thermoelectric cooler 130 via the heat conducting assembly and is then absorbed by the cold end, and the heat generated by the hot end of the thermoelectric cooler 130 and the heat generated by the transmitting coil 110 are both dissipated via the heat dissipation assembly, thus realizing the cooling and heat dissipation of the mobile terminal 200 and the transmitting coil 110. Since the heat dissipation assembly is located on an inner side of the wireless charging module 100, a driver on the outside can hardly perceive wind noise. Moreover, since there is no need to reserve space for an air duct between the heat conducting assembly and the mobile terminal 200, the problems of increased magnetic loss and low charging efficiency caused by a large distance between the transmitting coil 110 and the receiving coil due to the existence of the air duct is solved. In addition, no external foreign object will enter the air duct.

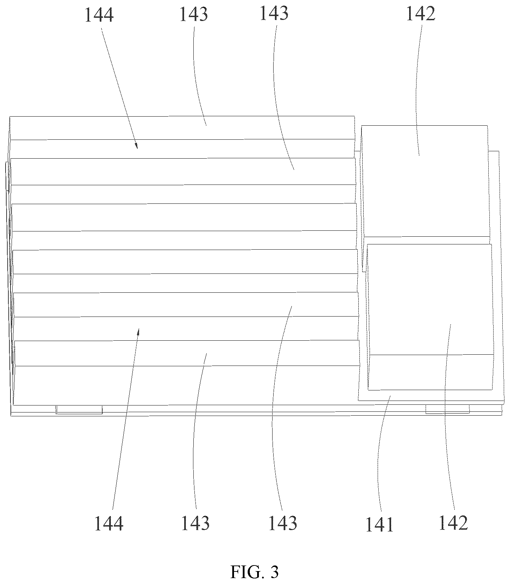

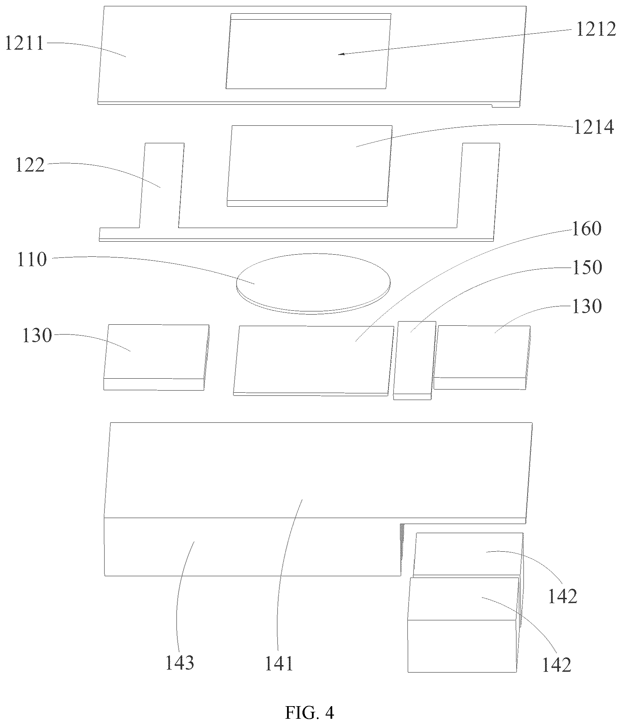

In an embodiment, with reference to FIGS. 3 and 4, the heat dissipation assembly includes a heat dissipation plate 141 and at least a fan 142. The heat dissipation plate 141 is thermally connected to both the hot end and the transmitting coil 110, and the fan 142 is located on a side of the heat dissipation plate 141 away from the transmitting coil 110.

Combined with FIGS. 2 to 4, heat generated by the control board 150 during operation, the heat generated by the transmitting coil 110 during operation and the heat generated by the hot end of the thermoelectric cooler 130 are all conducted to the heat dissipation plate 141. Airflow generated by the fan 142 takes away the heat of the heat dissipation plate 141 for heat dissipation.

In an embodiment, with reference to FIGS. 2 and 3, the heat dissipation assembly further includes heat dissipation fins 143. A plurality of the heat dissipation fins 143 are provided and are spaced apart and arranged in parallel on the heat dissipation plate 141, a heat dissipation gap 144 is formed between adjacent heat dissipation fins 143, and the fan 142 is capable of generating airflow towards the heat dissipation gap 144.

As shown in FIG. 3, a plurality of heat dissipation fins 143 are provided and are spaced apart and fixed in parallel on the heat dissipation plate 141, the heat of the heat dissipation plate 141 can be conducted to the heat dissipation fins 143, and the airflow generated by the fan 142 blows towards the heat dissipation gap 144, so as to take away the heat of the heat dissipation fins 143. Since the fan 142 and the heat dissipation fin 143 are both located on the side of the transmitting coil 110 away from the mobile terminal 200, it is not easy to perceive the wind noise on the outside of the wireless charging module 100.

As shown in FIG. 3, at least two fans 142 are provided. For example, it is possible to provide two fans 142 both located at the same end of the heat dissipation fin 143.

Optionally, a plurality of fans 142 are arranged in series or in parallel, so as to increase convection heat exchange efficiency of the heat dissipation fins 143 and reduce the wind noise.

Optionally, the heat dissipation fins 143 and the heat dissipation plate 141 are integrally formed, the fans 142 are spaced apart and fixed on the heat dissipation plate 141, and both the fans 142 and the heat dissipation fins 143 are located on the side of the heat dissipation plate 141 away from the transmitting coil 110.

In an embodiment, the heat dissipation assembly further includes a first heat conducting layer. The first heat conducting layer is arranged on the heat dissipation plate 141, and the first heat conducting layer is located on a side of the heat dissipation plate 141 away from the heat dissipation fins 143. The transmitting coil 110, the control board 150 and the thermoelectric cooler 130 are all located on the same side of the heat dissipation plate 141 and are thermally connected to the heat dissipation plate 141 by the first heat conducting layer.

The first heat conducting layer may be a thermally conductive glue or a thermally conductive pad. The first heat conducting layer may be made of a thermally conductive silicone grease material.

In an embodiment, with reference to FIG. 4, the wireless charging module 100 further includes a ferrite 160. The ferrite 160 is located between the first heat conducting layer and the transmitting coil 110.

As shown in FIG. 4, the ferrite 160 is located on the side of the transmitting coil 110 away from the mobile terminal 200, and the ferrite 160 conducts the heat generated by itself and the heat generated by the transmitting coil 110 to the heat dissipation plate 141 via the first heat conducting layer. Moreover, the ferrite 160 is also used for directing a magnetic field of the transmitting coil 110 towards the receiving coil, so as to reduce the magnetic loss.

In an embodiment, with reference to FIGS. 2, 4 and 5, the heat conducting assembly includes a heat conducting plate 121. The heat conducting plate 121 is located on a side of the transmitting coil 110 away from the heat dissipation plate 141, and the heat conducting plate 121 is used for contacting with the mobile terminal 200 and conducting the heat generated by the mobile terminal 200 to the cold end. The heat conducting plate 121 is provided with a first heat conducting part 1211 and a second heat conducting part 1214, the second heat conducting part 1214 is arranged through the first heat conducting part 1211, the second heat conducting part 1214 is positioned corresponding to the transmitting coil 110, and the second heat conducting part 1214 is made of a nonmetallic thermally conductive material.

As shown in FIG. 2, the first heat conducting part 1211 serves as a part that comes into contact with the mobile terminal 200. In order to avoid interfering with the electromagnetic induction between the transmitting coil 110 and the receiving coil, a part positioned corresponding to the transmitting coil 110 is configured as the second heat conducting part 1214 made of the nonmetallic thermally conductive material.

For example, the first heat conducting part 1211 may be made of a metallic material. The second heat conducting part 1214 may be made of a highly thermally conductive nonmetallic material, such as ceramics, marble or glass.

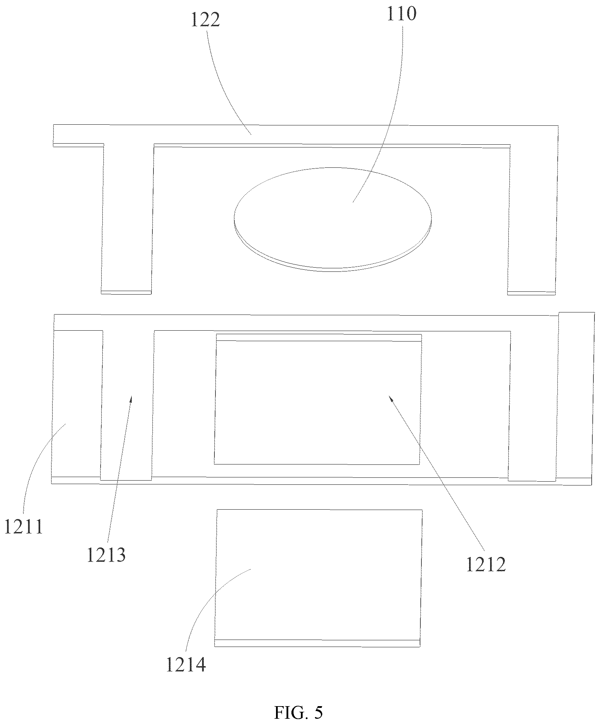

In an embodiment, with reference to FIGS. 4 and 5, the first heat conducting part 1211 is provided with a first through hole 1212, the first through hole 1212 is shaped corresponding to the second heat conducting part 1214, and the second heat conducting part 1214 is arranged in the first heat conducting part 1211 by the first through hole 1212.

As shown in FIGS. 2 and 5, the first through hole 1212 exactly matches the second heat conducting part 1214, such that the second heat conducting part 1214 precisely closes the first through hole 1212, and the first heat conducting part 1211 and the second heat conducting part 1214 are integrated, so as to maintain the appearance consistency of the wireless charging module 100 and also to place the mobile terminal 200.

Optionally, the second heat conducting part 1214 has a rectangular shape, and the first through hole 1212 is a rectangular through hole extending through the first heat conducting part 1211.

In an embodiment, with reference to FIGS. 4 and 5, the heat conducting assembly further includes a heat conducting pipe 122. The heat conducting pipe 122 is arranged on the heat conducting plate 121 and located on a side of the heat conducting plate 121 facing the thermoelectric cooler 130, and the heat conducting plate 121 is thermally connected to the thermoelectric cooler 130.

As shown in FIG. 4, the heat conducting pipe 122 is located between the heat conducting plate 121 and the heat dissipation plate 141. The heat conducting pipe 122 is used for further conducting the heat conducted by the heat conducting plate 121 to the cold end of the thermoelectric cooler 130, so as to improve heat conduction efficiency.

In an embodiment, with reference to FIG. 4, at least two thermoelectric coolers 130 are provided and are arranged around the periphery of the transmitting coil 110. The first heat conducting part 1211 is provided with a first mounting recess 1213, the first mounting recess 1213 is arranged around the periphery of the second heat conducting part 1214, the heat conducting pipe 122 is shaped corresponding to the first mounting recess 1213 and is arranged on the heat conducting plate 121 by the first mounting recess 1213, and the heat conducting pipe 122 is thermally connected to all of the thermoelectric coolers 130.

As shown in FIG. 4, two thermoelectric coolers 130 are provided, which are respectively located at two opposite ends of the transmitting coil 110 and are spaced apart from the transmitting coil 110. The control board 150 is located between one of the thermoelectric coolers 130 and the transmitting coil 110, so as to make the structure more compact.

The first mounting recess 1213 is provided on a side of the first heat conducting part 1211 facing the thermoelectric cooler 130. The first mounting recess 1213 is arranged around the periphery of the second heat conducting part 1214 for arranging the heat conducting pipe 122. As shown in FIG. 5, the first mounting recess 1213 extends generally in a U-shape, to match the U-shaped heat conducting pipe 122, making the structure more compact. The heat conducting pipe 122 is U-shaped, such that the heat conducting pipe 122 can be thermally connected to different thermoelectric coolers 130, and also avoid the transmitting coil 110.

In an embodiment, the heat conducting assembly further includes a second heat conducting layer. The second heat conducting layer is laid over the heat conducting plate 121 and the heat conducting pipe 122, and the thermoelectric cooler 130 is thermally connected to the heat conducting plate 121 and the heat conducting pipe 122 by the second heat conducting layer.

The second heat conducting layer is used for conducting the heat generated by the heat conducting plate 121 to the thermoelectric cooler 130, the control board 150 and the transmitting coil 110, and may be a thermally conductive glue or a thermally conductive pad.

In another aspect, the disclosure further provides a vehicle. The vehicle includes a wireless charging module 100 according to any one of the embodiments described above.

The vehicle includes the wireless charging module 100 as described above. Since the heat dissipation assembly is located on an inner side of the wireless charging module 100, and a driver on the outside can hardly perceive wind noise. Moreover, since there is no need to reserve space for an air duct between the heat conducting assembly and the mobile terminal 200, the problems of increased magnetic loss and low charging efficiency caused by a large distance between the transmitting coil 110 and the receiving coil due to the existence of the air duct is solved. In addition, no external foreign object will enter the air duct.

In the description of the disclosure, it should be understood that the orientation or position relationship indicated by the terms "central", "longitudinal", "transverse", "length", "width", "thickness", "upper", "lower", "front"; "rear", "left", "right", "vertical", "horizontal", "top", "bottom", "inner", "outer", "clockwise", "counterclockwise", "axial", "radial", "circumferential", etc. is based on the orientation or position relationship as shown in the accompanying drawings and is merely intended to facilitate and simplify the description of the disclosure, rather than indicating or implying that the device or element considered must have a particular orientation or be constructed and operated in a particular orientation, and therefore not to be construed as limiting the disclosure.

In addition, the terms "first" and "second" are merely used for descriptive purposes, and cannot be construed as indicating or implying relative importance or implicitly indicating the number of technical features indicated. Thus, the features defined with "first" and "second" can explicitly or implicitly include at least one of the features. In the description of the disclosure, the phrase "plurality" means at least two, such as two, three, etc., unless otherwise specifically defined.

In the disclosure, unless otherwise explicitly specified and defined, the terms such as "mount", "connected", "connection", and "fix" should be understood in a broad sense, for example, they may be a fixed connection, a detachable connection, or an integrated connection; may be a mechanical connection or an electrical connection; or may be a direct connection or an indirect connection via an intermediate medium, or may be communication between interiors of two elements or interaction between the two elements, unless otherwise specifically defined. For those of ordinary skill in the art, the specific meanings of the above terms in the disclosure can be understood according to specific situations.

In the disclosure, unless otherwise explicitly specified and defined, a first feature being "above" or "below" a second feature may indicate that the first feature is in direct contact with the second feature, or the first feature is in indirect contact with the second feature via a medium. Moreover, the first feature being "over", "above", and "on" the second feature may indicate that the first feature is directly above or obliquely above the second feature, or merely indicate that the level of the first feature is higher than the level of the second feature. The first feature being "under", "below" and "beneath" the second feature may indicate the first feature is directly below or obliquely below the second feature, or merely indicate that the level of the first feature is lower than the level of the second feature.

It should be noted that when an element is referred to as being "fixed to" or "arranged on" a further element, it may be directly on the further element, or there may be an intermediate element. When an element is referred to as being "connected" to a further element, it may be directly connected to the further element, or there may be an intermediate element. The terms "vertical", "horizontal", "upper", "lower", "left", "right", or the like used herein are merely for illustrative purposes and do not represent any unique implementation.

Any combination of the technical features of the above embodiments may be possible, and in order to simplify the descriptions, not all possible combinations of the technical features of the above embodiments are described. However, as long as there is no conflict between the combinations of these technical features, they should be considered to be within the scope of the description.

The above embodiments merely illustrate several implementations of the disclosure and are described relatively specifically and in detail, but should not be construed as limiting the patent scope of the disclosure. It should be noted that several variations and improvements may also be made by those of ordinary skill in the art without departing from the concept of the disclosure, and should fall within the scope of protection of the disclosure. Therefore, the scope of protection of the disclosure shall be subject to the appended claims.

## Claims

1. A wireless charging module, **characterized in that** the wireless charging module comprises:
a transmitting coil, the transmitting coil being used for cooperating with a mobile terminal to conduct charging;
a heat conducting assembly, the heat conducting assembly being used for contacting with the mobile terminal and conducting heat generated by the mobile terminal;
a thermoelectric cooler, the thermoelectric cooler being provided with a cold end and a hot end, and the cold end being thermally connected to the heat conducting assembly, so as to absorb the heat generated by the mobile terminal;
a heat dissipation assembly, the heat dissipation assembly being thermally connected to both the hot end and the transmitting coil, and the heat dissipation assembly being located on a side of the transmitting coil away from the mobile terminal; and
a control board, the control board being electrically connected to the transmitting coil and the thermoelectric cooler.

2. The wireless charging module according to claim 1, **characterized in that** the heat dissipation assembly comprises a heat dissipation plate and at least a fan, the heat dissipation plate being thermally connected to both the hot end and the transmitting coil, and the fan being located on a side of the heat dissipation plate away from the transmitting coil.

3. The wireless charging module according to claim 2, **characterized in that** the heat dissipation assembly further comprises heat dissipation fins, a plurality of the heat dissipation fins being provided and being spaced apart and arranged in parallel on the heat dissipation plate, a heat dissipation gap being formed between adjacent heat dissipation fins, and the fan being capable of generating airflow towards the heat dissipation gap.

4. The wireless charging module according to claim 3, **characterized in that** the heat dissipation assembly further comprises a first heat conducting layer, and wherein the first heat conducting layer is arranged on the heat dissipation plate, and the first heat conducting layer is located on a side of the heat dissipation plate away from the heat dissipation fins; and the transmitting coil, the control board and the thermoelectric cooler are all located at the same side of the heat dissipation plate and are thermally connected to the heat dissipation plate by the first heat conducting layer.

5. The wireless charging module according to claim 4, **characterized in that** the wireless charging module further comprises a ferrite, wherein the ferrite is located between the first heat conducting layer and the transmitting coil.

6. The wireless charging module according to any one of claims 2-5, **characterized in that** the heat conducting assembly comprises a heat conducting plate, and wherein the heat conducting plate is located on a side of the transmitting coil away from the heat dissipation plate, and the heat conducting plate is used for contacting with the mobile terminal and conducting the heat generated by the mobile terminal to the cold end; and the heat conducting plate is provided with a first heat conducting part and a second heat conducting part, the second heat conducting part is arranged through the first heat conducting part, the second heat conducting part is positioned corresponding to the transmitting coil, and the second heat conducting part is made of a nonmetallic thermally conductive material.

7. The wireless charging module according to claim 6, **characterized in that** the first heat conducting part is provided with a first through hole, the first through hole is shaped corresponding to the shape of the second heat conducting part, and the second heat conducting part is arranged in the first heat conducting part by the first through hole.

8. The wireless charging module according to claim 6, **characterized in that** the heat conducting assembly further comprises a heat conducting pipe, the heat conducting pipe being arranged on the heat conducting plate and located on a side of the heat conducting plate facing the thermoelectric cooler, and the heat conducting plate being thermally connected to the thermoelectric cooler.

9. The wireless charging module according to claim 8, **characterized in that** at least two thermoelectric coolers are provided and are arranged around the periphery of the transmitting coil; the first heat conducting part is provided with a first mounting recess, the first mounting recess is arranged around the periphery of the second heat conducting part, the heat conducting pipe is shaped corresponding to the first mounting recess and is arranged on the heat conducting plate by the first mounting recess, and the heat conducting pipe is thermally connected to all of the thermoelectric coolers; or/and
the heat conducting assembly further comprises a second heat conducting layer, the second heat conducting layer being laid over the heat conducting plate and the heat conducting pipe, and the thermoelectric cooler being thermally connected to both the heat conducting plate and the heat conducting pipe by the second heat conducting layer.

10. A vehicle, **characterized in that** the vehicle comprises a wireless charging module according to any one of claims 1-9.
